# EUROPEAN PATENT APPLICATION

(11) **EP 4 079 930 A1**
(43) Date of publication of application: **26.10.2022**
(21) Application number: 21169208.2
(22) Date of filing: 19.04.2021
(51) Int. Cl.: C23C 16/26, C23C 16/34, C23C 16/52, C23C 14/06, G01N 21/21, G02B 5/30, G06T 7/00, C23C 14/54, G01N 21/84, G01Q 60/60, G01Q 70/12, G02B 1/08, C01B 32/186

(54) **METHOD OF VISUALIZING A DISTRIBUTION AND AN INTRINSIC ORIENTATION OF PERIODICALLY SPACED ONE-DIMENSIONAL STRUCTURES IN TWO-DIMENSIONAL MATERIALS**

(71) Applicant: Martin-Luther-Universität Halle-Wittenberg, 06108 Halle (Saale) (DE)
(72) Inventor: Dr. AMADO, Elkin, 06108 Halle (Saale) (DE); Prof. Dr. KREßLER, Jörg, 06114 Halle (Saale) (DE)
(74) Representative: Louis Pöhlau Lohrentz

(57) **Abstract**

The invention refers to a method of visualizing a distribution and an intrinsic orientation of periodically spaced one-dimensional structures by optical microscopy.

The periodically spaced one-dimensional structures are distributed inside a single domain or inside multiple domains on a two-dimensional material.

Inside each domain, the periodically spaced one-dimensional structures run essentially in parallel. The distance between adjacent periodically spaced one-dimensional structures is in the range of 50 nm - 1000 nm, preferably in the range of 100 nm - 800 nm, more preferably in the range of 200 nm - 600 nm, most preferably in the range of 250 nm - 500 nm. The method comprises the following steps:
a) depositing an electrically conductive solid film of an imaging material onto the surface of the two-dimensional material to obtain a layered composite,
b) providing a polarization microscope,
c) imaging the layered composite obtained in step a) at different acquisition angles by polarized optical microscopy using the polarization microscope and analyzing the images to determine the distribution and the orientation of the periodically spaced one-dimensional structures inside the respective domains.

## Description

The present invention relates to a method of visualizing a distribution and an intrinsic orientation of periodically spaced one-dimensional structures in domains of two-dimensional materials.

The patent application US 2016 / 0 148 369 A1 discloses a method of observing major microscopic defects generated in the process of growing a two-dimensional material, such as grain boundaries, cracks, holes and multilayer patches, by depositing a detection material. The deposition method may be atomic layer deposition (ALD), chemical vapor deposition (CVD) or sputtering. In the known method, the detection material is selectively deposited only and exclusively on these major microscopic defects. Thus, only these defects can be observed by the known method.

Typical techniques operating for visualizing structures in the range of a few hundreds of nanometers are atomic force microscopy (AFM), scanning tunneling microscopy (STM) or transmission electron microscopy (TEM). These techniques are limited to cover areas typically in the range of 1 x 1 µm² up to 100 x 100 µm² at most. In contrast, the size of current samples of two-dimensional materials, e. g. samples of graphene produced by chemical vapor deposition (CVD), also called CVD graphene, is in the order of one to several cm² or even several dm², with the most recent roll-to-roll production process. Thus, there is a huge mismatch of at least 4 to 6 orders of magnitude between the areas technically feasible to be investigated in a single run by the typical characterization methods and the actual size of current samples of two-dimensional materials, e. g. CVD graphene samples. For practical applications, such methods are unsuitable to check the topography of a whole sample of a two-dimensional material as CVD graphene due to unrealizable demands of measuring time and human resources, plus associated costs. Additionally, they require expensive, specialized, large equipment and trained operators.

Another typical technique for visualizing structures in the range of a few hundred nanometers is scanning electron microscopy (SEM). However, this technique is limited to areas of at most 400 x 400 µm², which are still too small compared to the size of current samples of CVD two-dimensional materials. Additionally, SEM provides enough contrast, only as long as the two-dimensional material is still deposited on the metallic substrate used for the synthesis. The contrast is lost once the two-dimensional material is transferred to other substrates.

The object underlying the present invention is to provide an inexpensive, facile, speedy and broadly available method suitable for visualizing the orientation of periodic nanoscopic structures inside essentially microscopic domains on two-dimensional materials. Furthermore, the inventive method shall cope with the visualization of large areas up to several dm². Furthermore, a production method comprising the above method of visualization is to be provided.

The object is achieved by the features of claim 1 regarding the method of visualization, and claim 15 regarding the production method. Expedient embodiments of the invention result from the dependent claims.

In accordance with the invention, the method of visualizing a distribution and an intrinsic orientation of periodically spaced one-dimensional structures is performed by using optical microscopy. The periodically spaced one-dimensional structures are distributed inside a single domain or inside multiple domains on a two-dimensional material. The periodically spaced one-dimensional structures are preferably distributed inside a single domain or inside multiple domains all over the two-dimensional material. Inside each domain, the periodically spaced one-dimensional structures run essentially in parallel. The distance between adjacent periodically spaced one-dimensional structures is in the range of 50 nm - 1000 nm, preferably in the range of 100 nm - 800 nm, more preferably in the range of 200 nm - 600 nm, most preferably in the range of 250 nm - 500 nm. Therefore, the periodically spaced one-dimensional structures are spaced in the submicron range and can also be called periodically submicron-spaced one-dimensional structures.

The two-dimensional material preferably contains multiple domains. The domains form areas delimited from each other. These domains preferably result from the production of the two-dimensional material on a preferably polycrystalline metal used as a substrate. However, a single crystal of a metal can alternatively be used as a substrate. The domains of the two-dimensional material preferably match the domains of the polycrystalline metal used as substrate. More precisely, the topography of the domains of the polycrystalline metal is closely transferred to the two-dimensional material during its production process which is preferably performed by chemical vapor deposition (CVD). The domains of the polycrystalline metal correspond with the individual grains or crystallites of the polycrystalline metal or with individual twins eventually present inside some grains or crystallites of the polycrystalline metal. Such twins are areas delimited by straight parallel twin boundaries. The lattice orientation of an individual twin preferably mirrors that of its neighboring twin. In other words, the lattice orientation of an individual twin is preferably mirror-inverted with respect to its neighboring twin. Furthermore, the lattice orientation preferably changes abruptly at the twin boundary.

The domains of the two-dimensional material are essentially microscopic domains, preferably microscopic domains. The domains have sizes of about 1 µm to 50 cm, preferably of 5 µm to 5 mm, more preferably of 10 µm to 2 mm, more preferably of 20 µm to 1000 µm, most preferably of 40 µm to 800 µm. The domains preferably have a polygonal form.

In the sense of the present invention, no strict requirements are placed on the term "periodically". In fact, this term can preferably be understood as essentially periodically or "quasi-periodically". In more detail, fluctuations in the periodicity of the distance between adjacent one-dimensional structures are allowed. These fluctuations are preferably below 40 %, more preferably below 20 %, and most preferably below 10 %. Furthermore, the distance between adjacent periodically spaced one-dimensional structures can vary from domain to domain.

In the sense of the present invention, one-dimensional structures are not necessarily strictly mathematically one-dimensional. In fact, the one-dimensional structures preferably have a certain extension in the second and in the third dimension. However, the extension in the first dimension is preferably at least 25 times the extension in the second and/or third dimension, more preferably at least 5000 times the extension in the second and/or third dimension, more preferably at least 10000 times the extension in the second and/or third dimension, most preferably at least 25000 times the extension in the second and/or third dimension.

The one-dimensional structures are preferably nanoripples. The nanoripples preferably result from the production of the two-dimensional material on a substrate, e. g. on a polycrystalline metal. The nanoripples preferably correspond with the atomic steps present on the surface of the metallic substrate. More precisely, the nanoripples result from a kind of stamping or embossment of the atomic steps onto the growing two-dimensional material.

The one-dimensional structures, e. g. nanoripples, are preferably straight. Alternatively or additionally, the one-dimensional structures, e. g. nanoripples, can have a curvature. In particular, the one-dimensional structures, e. g. nanoripples, can follow a straight line in one or more sections and can have a curvature in other one or more sections. The curvature can preferably vary along the one-dimensional structures, e. g. along the nanoripples.

As claimed, inside each domain, the one-dimensional structures, e. g. nanoripples, run essentially in parallel. Thus, the one-dimensional structures, e. g. nanoripples, may run strictly in parallel. However, in the sense of the present invention, the one-dimensional structures, e. g. nanoripples, do not necessarily have to run strictly in parallel. The distance from a given one-dimensional structure, e. g. from a given nanoripple, to the adjacent one-dimensional structure, e. g. nanoripple, preferably varies in a percentage of less than 20 % along the length of the one-dimensional structure, e. g. along the length of the nanoripple, more preferably less than 10 %, and most preferably less than 5 %.

The one-dimensional structures, e. g. nanoripples, from different domains can have any orientation relative to each other. Thus, the one-dimensional structures, e. g. nanoripples, from different domains generally do not run in parallel.

The method comprises the following steps:
a) depositing an electrically conductive solid film of an imaging material onto the surface of the two-dimensional material to obtain a layered composite,
b) providing a polarization microscope,
c) imaging the layered composite obtained in step a) at different acquisition angles by polarized optical microscopy using the polarization microscope and analyzing the images to determine the distribution and the orientation, preferably the relative and/or the absolute orientation, of the periodically spaced one-dimensional structures, preferably the orientation of the nanoripples, inside the respective domains, preferably inside the respective microscopic domains.

It has been found that the deposition of the electrically conductive solid film of the imaging material onto the surface of the two-dimensional material carried out in step a) enables to visualize the topography of the two-dimensional material by imaging techniques such as polarized optical microscopy. In particular, the imaging material advantageously reveals the distribution of the microscopic domains of the two-dimensional material and additionally generates a varying brightness of the domains according to the orientation of the periodically spaced one-dimensional structures, e. g. nanoripples, inside the domains. The imaging material advantageously provides in this way an optimal contrast making it possible to see the domains of the two-dimensional material, which are otherwise invisible to common or polarized optical microscopy. Furthermore, it preferentially enables the visualization of the one-dimensional structures, e. g. nanoripples, not only by polarized optical microscopy but also by complementary microscopy techniques such as Raman microscopy or/and atomic force microscopy (AFM) (see below).

In step a), the imaging material is preferably deposited evenly all over the entire surface of the two-dimensional material. Alternatively, the imaging material can be evenly deposited onto just a predetermined area of the two-dimensional material. Accordingly, the two-dimensional material can be selectively covered with a mask during step a), wherein the predetermined area remains unmasked. The mask hinders the deposition of the imaging material. Thus, the imaging material is deposited only onto the predetermined area outside the mask. Accordingly, the predetermined area of the two-dimensional material can also be called unmasked area. Furthermore, there can be several predetermined areas which remains unmasked during step a), i. e. several unmasked areas. The mask is preferably removed after performing step a).

The polarization microscope provided in step b) is preferably an optical microscope additionally having two polarizing filters, an analyzer filter (A) and a polarizer filter (P), with their optical axes aligned orthogonally to each other, and optionally a rotatable specimen stage.

For imaging the layered composite at different acquisition angles in step c), preferably, the sample is rotated step-by-step and a separate image is taken at each acquisition angle. Thereby, the sample is preferably rotated in the XY plane, i. e. in the horizontal plane. Alternatively, the polarization microscope can be rotated in the XY plane, i. e. in the horizontal plane. Preferably, the sample is not tilted with respect to the horizontal plane and the light impinges normal to the surface of the sample.

Preferably, the sample is rotated step-by-step from the initial position at angle 0° one complete turn up to 360° with a constant angular increment. The angular increment is preferably chosen between 0,1° and 45°, more preferably between 0,5° and 15°, most preferably between 1° and 10°. Thus, the difference in the acquisition angle of consecutively taken images is preferably constant. For example, 18 images are taken with a constant angular increment of 20°.

In the respective images, preferably the same domains are observed at different acquisition angles. According to the acquisition angle, the color and/or the brightness of the individual domains changes depending on the respective orientation of the periodically spaced one-dimensional structures, e. g. of the nanoripples, inside each domain. The relative orientation of the individual domains is preferably evaluated depending on the succession of the color and/or the brightness of the individual domains. Domains which show the same succession have preferably the same orientation of the periodically spaced one-dimensional structures, e. g. of the nanoripples. Furthermore, when a domain shows a succession shifted by a certain angular offset with respect to another domain, the orientation of the periodically spaced one-dimensional structures, e. g. of the nanoripples, between both domains differs also by this angular offset. Thus, by imaging the samples at different acquisition angles, the relative angles of orientation of the periodically spaced one-dimensional structures, e. g. of the nanoripples, in the respective domains can be determined.

The step c) is preferably carried out to determine the relative orientation of the periodically spaced one-dimensional structures, preferably the orientation of the nanoripples, inside the respective domains, preferably inside the respective microscopic domains.

In knowledge of any absolute orientation of the periodically spaced one-dimensional structures, e. g. of the nanoripples, inside one domain, the absolute orientations of the periodically spaced one-dimensional structures, e. g. of the nanoripples, in all other domains can be known after determining the corresponding angular offsets between the domains. The relative orientation of the periodically spaced one-dimensional structures, e. g. of the nanoripples, in the respective domains and the absolute orientation of the periodically spaced one-dimensional structures, e. g. of the nanoripples, in a single specific domain are preferably combined for determining the absolute orientation of the periodically spaced one-dimensional structures, e. g. of the nanoripples, in the respective domains.

The relative and/or absolute orientation of the periodically spaced one-dimensional structures, e.g. of the nanoripples, in a specific domain can also be determined by complementary microscopy methods such as Raman microscopy and/or atomic force microscopy (AFM) (see below).

Alternatively, in step c), the absolute orientation of the periodically spaced one-dimensional structures, e. g. of the nanoripples, inside a specific domain can be determined. In a first step, the angular dependence of the brightness in a set of images of a specific domain for a complete 0° to 360° rotation of the sample is preferably determined with both, the polarizer filter and the analyzer filter, positioned in the optical path of the polarization microscope. The brightness goes through a minimum at four angles located along two orthogonal axes. One of these axes is preferably parallel to the optical axis of the analyzer filter and the other one parallel to the optical axis of the polarizer filter. In a second step, the sample is investigated aligned with any one of these two axes, but this time the analyzer filter is removed from the optical path. The brightness of the specific domain will either become higher compared to the rest of the sample, in which case the orientation of the periodically spaced one-dimensional structures, e. g. of the nanoripples, inside the domain runs perpendicular to the optical axis of the analyzer, or it will remain minimal compared to the rest of the sample, in which case the orientation of the periodically spaced one-dimensional structures, e. g. of the nanoripples, inside the domain runs parallel to the optical axis of the analyzer. This determination of the absolute orientation of the periodically spaced one-dimensional structures, e. g. of the nanoripples, is advantageous if the images exhibit still enough contrast between the different domains after the analyzer is removed from the optical path.

Thus, by performing step c), based on the determination of the relative orientation of the periodically spaced one-dimensional structures, e. g. of the nanoripples, in the respective domains and based on the determination of the absolute orientation of the periodically spaced one-dimensional structures, e. g. of the nanoripples, in just one of those domains, the absolute orientation of the periodically spaced one-dimensional structures, preferably the orientation of the nanoripples, inside the respective domains, preferably inside the respective microscopic domains can be determined.

It has been found that the electrical properties such as the charge mobility of the two-dimensional material depend on the surface density of the periodically spaced one-dimensional structures, preferably on the surface density of the nanoripples. Since the distribution of the periodically spaced one-dimensional structures, e. g. of the nanoripples, is anisotropic, their surface density along a given direction depends on the orientation of the periodically spaced one-dimensional structures, e. g. of the nanoripples, with respect to this direction. Thus, it is of great interest to determine the distribution and the orientation of the periodically spaced one-dimensional structures, in particular of the nanoripples, inside the respective domains in two-dimensional materials.

The inventive method advantageously provides an inexpensive, facile, speedy and broadly available method suitable for visualizing the distribution and the orientation of periodically spaced one-dimensional structures inside domains, preferably inside microscopic domains, on two-dimensional materials. Advantageously, the inventive method can cope with large areas of up to several cm² in a single measurement and up to several dm² if several images are stitched together into a composite image.

Furthermore, the inventive method advantageously requires simple equipment and can be performed by a technician or undergraduate student.

Furthermore, the deposition of the electrically conductive solid film of the imaging material onto the surface of the two-dimensional material (see step a)) is preferably carried out under mild process conditions. Preferably, the deposition according to step a) is reversible under moderate conditions. Thus, the inventive method advantageously is non-destructive and can be used for the characterization of two-dimensional materials prior to the production of electronic devices involving such two-dimensional materials.

According to an advantageous embodiment of the invention, the two-dimensional material is produced by chemical vapor deposition (CVD), atomic layer deposition, physical vapor deposition (PVD), sputtering, evaporation and/or epitaxy.

According to a further advantageous embodiment of the invention, the two-dimensional material is produced on a metallic substrate, wherein the metallic substrate is preferably polycrystalline or a single crystal.

As the metallic substrate, copper (Cu), nickel (Ni), Cobalt (Co), Palladium (Pd), Platinum (Pt), Iridium (Ir), Ruthenium (Ru), Rhenium (Re), Rhodium (Ro), Gold (Au) or Cu-Ni alloys are preferably used. The metallic substrate is preferably formed by multiple grains or crystallites. A domain of the polycrystalline metallic substrate corresponds either with an individual grain or crystallite of the polycrystalline metallic substrate or with an individual twin eventually present inside a grain or crystallite of the polycrystalline metallic substrate. As already explained above, the topography of the domains of the polycrystalline metallic substrate is closely transferred to the two-dimensional material during its production process which is preferably performed by chemical vapor deposition (CVD). Thus, the domains of the two-dimensional material correspond with the domains of the polycrystalline metallic substrate. In other words, the domains of the two-dimensional material result from a kind of stamping or embossment of the domains of the polycrystalline metal onto the growing two-dimensional material.

Furthermore, the metallic substrate preferably has atomic steps on its surface. As explained above, the one-dimensional structures, e. g. the nanoripples, preferably result from the production of the two-dimensional material on the metallic substrate. The one-dimensional structures, e. g. the nanoripples, preferably correspond with the atomic steps present on the surface of the metallic substrate. More precisely, the one-dimensional structures, e. g. the nanoripples, can result from a kind of stamping or embossment of the atomic steps onto the growing two-dimensional material.

The two-dimensional material is preferably removed from the metallic substrate before carrying out the steps a) to c) of the inventive method. The removal is preferably carried out by etching away the metallic substrate. The two-dimensional material is preferably transferred onto a flat substrate before carrying out the steps a) to c) of the inventive method. The flat substrate is preferably made of Si, SiO₂, Germanium (Ge), quartz and/or glass. The presence of individual domains, preferably microscopic domains, and the periodically spaced one-dimensional structures, e. g. of the nanoripples, advantageously withstands the removal from the metallic substrate and/or the transfer onto the flat substrate.

According to a further advantageous embodiment of the invention, the two-dimensional material is graphene, preferably a single layer of graphene, or hexagonal boron nitride (h-BN), preferably a single layer of hexagonal boron nitride (h-BN).

The two-dimensional material has preferably a size of 1 mm² to 1 m², more preferably a size of 25 mm² to 50 dm², and most preferably a size of 1 cm² to 10 dm².

According to a further advantageous embodiment of the invention, the periodically spaced one-dimensional structures, e. g. the nanoripples, form lengthy essentially parallel corrugations having a height in the range of 0,5 nm to 10 nm, preferably a height in the range of 0,6 nm to 6 nm, more preferably a height in the range of 0,8 nm to 4,2 nm, most preferably a height of about 2,5 nm.

The periodically spaced one-dimensional structures, e. g. the nanoripples, preferably have a width in the range of 75 nm to 150 nm, more preferably a width in the range of 95 nm to 120 nm, most preferably a width of about 100 nm.

The periodically spaced one-dimensional structures, e. g. the nanoripples, preferably have a length of about 500 nm to 50 cm, more preferably of 1 µm to 1 cm, more preferably of 1,5 µm to 5 mm, most preferably of 2 µm to 1000 µm.

According to a further advantageous embodiment of the invention, the imaging material is electrically conductive. The electrical conductivity at room temperature is preferably in the range of 40 to 7x10⁵ (Ohm*cm)⁻¹, equivalent to 4000 to 7x10⁷ S*m⁻¹.

Furthermore, the imaging material is preferably deposited shaped as nanometer-size elements. The orientation of the nanometer-size elements is preferably dictated by the orientation of the periodically spaced one-dimensional structures, e. g. the nanoripples, of the two-dimensional material.

The nanometer-size elements are preferably electrically conductive nanowires, nanotubes, nanofibers and/or chains of nanoparticles. The nanometer-size elements preferably have diameters and/or widths in the range of 20 nm to 200 nm, most preferably in the range of 40 nm to 180 nm and most preferably in the range of 55 nm to 160 nm. In the case of non-circular cross sections, these values apply to the width of the nanometer-size elements. Furthermore, the nanometer-size elements preferably have lengths in the range of 100 nm to 100 µm, preferably in the range of 500 nm to 40 µm, and most preferably in the range of 1 µm to 20 µm.

According to a further advantageous embodiment of the invention, the imaging material is an electrically conductive polymer, in particular (SN)ₓ, preferably shaped as chains of nanoparticles and/or nanofibers. The polymer is preferably anisotropic and/or unidimensional. (SN)ₓ stands for polymeric sulfur nitride and is also known as polythiazyl in older literature.

Alternatively, the imaging material is a metal shaped as nanowires and/or nanotubes, in particular nanowires and/or nanotubes, in particular silver nanowires, tellurium nanowires and/or tellurium nanotubes.

According to a further advantageous embodiment of the invention, the imaging material is deposited onto the surface of the two-dimensional material in step a) by means of thermal vaporization. The thermal vaporization is preferably performed at 10⁻⁸ to 20 mbar, i. e. at sub-atmospheric conditions under moderate vacuum, in high vacuum or in ultra-high vacuum (UHV). More preferably, the thermal vaporization is performed at 10⁻⁶ to 0,5 mbar, most preferably at 10⁻⁴ to 10⁻¹ mbar. The precursor of the imaging material is preferably kept at a temperature above its transition temperature at the prevailing pressure, while the two-dimensional material is kept at a temperature below the transition temperature of the imaging material.

In the case of providing (SN)ₓ as imaging material, the thermal vaporization is preferably performed under high vacuum, preferably at 10⁻⁵ to 1 mbar, more preferably at 10⁻⁴ to 0,5 mbar and most preferably at 5*10⁻⁴ to 0,25 mbar.

The thermal vaporization is preferably performed by heating (SN)ₓ crystals to a temperature in the range of 145 to 180 °C, more preferably to a temperature in the range of 155 to 175°C, such as to about 170°C.

The silver nanowires are preferably formed from the thermal vaporization of silver (I) oxide (Ag₂O) as precursor. This thermal vaporization is preferably performed in an argon vacuum of 6,7 to 13,3 mbar. The thermal vaporization is preferably performed by heating the precursor to a temperature of 500°C.

The tellurium nanowires or tellurium nanotubes are formed from the thermal vaporization of tellurium. This thermal vaporization is preferably performed in an argon vacuum of 1,3 to 2 mbar. The thermal vaporization is preferably performed by heating the tellurium to a temperature of 150 to 200°C.

During the thermal vaporization, the two-dimensional material is preferably cooled to a temperature in the range of -10 to 35 °C, more preferably to a temperature in the range of -5 to 25°C and most preferably to about 2°C. Thus, during the thermal vaporization, the precursor of the imaging material is preferably heated, while the two-dimensional material is cooled.

According to a further advantageous embodiment of the invention, the quantity of the imaging material deposited in step a) is large enough to evenly cover the entire surface of the two-dimensional material or of a selected area of the two-dimensional material with imaging material. The quantity of the imaging material deposited in step a) can also be large enough to cover essentially the entire surface of the two-dimensional material or of a selected area of the two-dimensional material with imaging material.

According to a further advantageous embodiment of the invention, in step a), between 1 and 20 layers of the imaging material, preferably between 2 and 10 layers of the imaging material and most preferably between 3 and 4 layers of the imaging material are deposited onto the surface of the two-dimensional material. In particular, the deposition of between 3 and 4 layers is preferred in the example of (SN)ₓ forming the imaging material.

Preferably, the thickness of one individual layer of (SN)ₓ deposited in method step a) is in the range of 5 to 30 nm, preferably in the range of 8 to 25 nm and most preferably in the range of 12 to 20 nm.

Although it is possible to deposit several layers of the imaging material onto the surface of the two-dimensional material, a progressive decrease in the contrast of the images obtained in method step c) is observed with increasing number of layers deposited in excess of four layers.

According to a further advantageous embodiment of the invention, the following step is performed before or after performing step c):
d) imaging the layered composite obtained in step a) by complementary microscopy methods, preferably by Raman microscopy or/and by atomic force microscopy (AFM).

By providing this additional step d), the absolute orientation of the periodically spaced one-dimensional structures, e. g. of the nanoripples, inside one specific domain can be determined.

Advantageously, the absolute orientation of the periodically spaced one-dimensional structures, e. g. of the nanoripples, inside one specific domain can be determined with high accuracy from AFM measurements. The additional step d) can offer an alternative for determining the absolute orientation of the periodically spaced one-dimensional structures, e. g. of the nanoripples, inside one specific domain. Furthermore, the additional step d) can be complementary to the determination performed in step c). Additionally, the distance between adjacent periodically spaced one-dimensional structures, in particular the distance between adjacent nanoripples, together with its periodicity can be determined from AFM measurements.

Furthermore, the absolute and/or relative orientation of the periodically spaced one-dimensional structures, e. g. of the nanoripples, inside different domains can be determined from Raman microscopy measurements, and be compared against the relative orientation determined in step c).

Based on the determination of the relative orientation of the periodically spaced one-dimensional structures, e. g. of the nanoripples, in the respective domains by performing step c) and based on the determination of the absolute orientation of the periodically spaced one-dimensional structures, e. g. of the nanoripples, in just one of those domains by performing step d), the following step can be performed:
d1) determining the absolute orientation of the periodically spaced one-dimensional structures, preferably the orientation of the nanoripples, inside the respective domains, preferably inside the respective microscopic domains.

Thus, the advantages of covering large areas up to several dm² provided by the polarized optical microscopy and of determining the absolute orientation of the periodically spaced one-dimensional structures, e. g. of the nanoripples, in one specific domain with high accuracy provided by the complementary microscopy methods such as atomic force microscopy (AFM) are advantageously combined.

According to a further advantageous embodiment of the invention, the film of imaging material deposited in step a) is removable from the two-dimensional material. Thus, advantageously, the inventive method is non-destructive and does not alter the two-dimensional material. After determining the orientation of the periodically spaced one-dimensional structures, e. g. of the nanoripples, by the inventive method, the two-dimensional material can advantageously be processed to be used in a final product.

According to a further advantageous embodiment of the invention, the following step is performed after performing the step c) and/or after step d):
e) removing the film of imaging material deposited in step a).

Thus, the deposition of the electrically conductive solid film of an imaging material onto the surface of the two-dimensional material from step a) is preferably reversible. The method according to the present application can be used for the non-destructive topographical characterization of the two-dimensional material, e. g. of a single layer of graphene, prior to the production of electronic devices, e. g. of electronic devices using such a layer of graphene.

In the case of providing (SN)ₓ as imaging material, the film of the imaging material can be preferably removed under similar processing conditions as those used in step a).

In accordance with the invention, the use of (SN)ₓ deposited on a two-dimensional material, preferably on graphene or on hexagonal boron nitride (h-BN), in polarized optical microscopy is claimed, preferably according to the inventive method of visualization.

Furthermore, in accordance with the invention, a method of production of a two-dimensional material, preferably of graphene or hexagonal boron nitride (h-BN), is claimed. The method of production comprises the inventive method of visualization for controlling the quality of the two-dimensional material, in particular the quality of graphene or of hexagonal boron nitride (h-BN).

The two-dimensional material, in particular graphene or hexagonal boron nitride (h-BN), is preferably produced by the CVD process using a polycrystalline metal or a single crystal of a metal as a substrate.

The two-dimensional material, in particular graphene or hexagonal boron nitride (h-BN), can be produced as an end product. Preferably, the two-dimensional material, in particular graphene or hexagonal boron nitride (h-BN), is used as part of electronic devices, particularly electronic displays and biosensor platforms. Furthermore, the inventive method can be used in the characterization of experimental devices in research activities involving graphene or hexagonal boron nitride (h-BN).

For these applications, the inventive method is an alternative to techniques generally used to characterize the topography of the two-dimensional material and to control the quality of the two-dimensional material, in particular of graphene or hexagonal boron nitride (h-BN).

The implementation of the inventive method in the production of the two-dimensional material, preferably of graphene or hexagonal boron nitride (h-BN), advantageously provides an inexpensive, facile, speedy and broadly available method suitable for controlling the quality of the two-dimensional material. Advantageously, the inventive method can cope with large areas of the two-dimensional material of up to several cm² in a single measurement and up to several dm² if several images are stitched together into a composite image.

Furthermore, advantageously, the inventive method is non-destructive and does not alter the two-dimensional material. After controlling the quality of the two-dimensional material by the inventive method, the two-dimensional material can advantageously be processed to be used in a final product.

The invention is now explained in more detail with reference to embodied examples. There are shown in
- Fig. 1: a schematic representation of the topography of CVD single-layer graphene across different length scales,
- Fig. 2: a comparison of polarized optical microscopy images of a first sample of CVD single-layer graphene on SiO₂/Si substrate before and after the deposition of (SN)ₓ,
- Fig. 3: a magnified view of the polarized optical microscopy image of the first sample of CVD single-layer graphene on SiO₂/Si substrate after the deposition of (SN)ₓ,
- Fig. 4: a comparison of polarized optical microscopy images of a second sample of CVD single-layer graphene on SiO₂/Si substrate before and after the deposition of (SN)ₓ,
- Fig. 5: polarized optical microscopy images of a third sample of CVD single-layer hexagonal boron nitride on SiO₂/Si substrate after the deposition of (SN)ₓ imaged with and without crossed analyzer,
- Fig. 6: a sequence of polarized optical microscopy images of the first sample of CVD single-layer graphene on SiO₂/Si substrate for determining the orientation of the periodically spaced nanoripples by imaging the sample at different angles of rotation, and
- Fig. 7: images of the layered composite of (SN)ₓ on the first sample of CVD single-layer graphene on SiO₂/Si substrate by complementary microscopy methods.

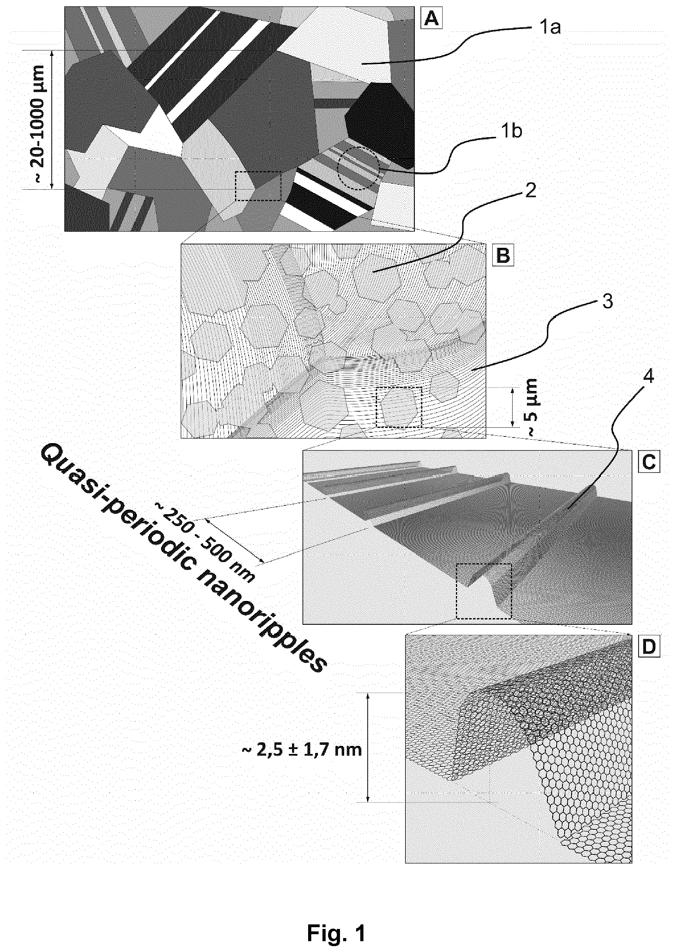

The Fig. 1 shows a schematic representation of the topography of single-layer graphene. The single-layer graphene is produced by chemical vapor deposition (CVD) on a polycrystalline metal substrate, e. g. a polycrystalline copper foil substrate. Since the CVD procedure is carried out at high temperatures of around 800-1050°C, multiple annealing twins are present inside some of the grains on the surface of the metal substrate.

In Fig. 1, from image A to image D, different length scales are shown. According to image A, the polycrystalline metal substrate presents multiple domains which correspond with individual grains or crystallites of the polycrystalline metal or with individual twins eventually present inside some grains or crystallites. Such twins are delimited by straight parallel twin boundaries. In the shown example, the grains have a size of about 20 µm to 1000 µm. In fact, image A corresponds with the stamp or embossment of the domains of the polycrystalline metal substrate left on the single-layer graphene after growing on top of the polycrystalline metal substrate. Accordingly, the distribution of domains on the single-layer graphene are shown in image A. These domains have a size of about 20 µm to 1000 µm corresponding with the size of the individual grains 1a of the polycrystalline metal substrate or with twins 1b eventually present inside some grains of the polycrystalline metal substrate.

Image B of Fig. 1 is a schematic magnified representation of a region from image A, where three different domains meet. Image B refers to two aspects:

First, it shows how a monolayer of graphene is formed through the coalescence of individual hexagonal crystals or grains 2. The graphene grains 2 reach about 10 to 20 µm size at the point of coalescence. In image B of Fig. 1, an intermediate stage having less than 100% coverage is shown. This representation is only shown for illustrating the growth and coalescence of graphene crystals or grains 2 during the CVD synthesis. In fact, according to the present application, a complete monolayer of graphene with 100% coverage is referred to. After the coalescence of the shown hexagonal graphene crystals or grains 2, the boundaries between the different crystals or grains 2 are perfectly flat and invisible to common or polarized optical microscopy and even invisible to atomic force microscopy (AFM). These boundaries are normally observed by instrumental methods yielding atomic resolution such as scanning tunneling microscopy (STM). Thus, the present application does not refer to the boundaries between graphene crystals or grains 2.

The second aspect shown in image B of Fig. 1 refers to the internal topography of the domains. According to image B, the polycrystalline metal substrate is fully covered by atomic steps 3 present within each domain. These atomic steps run nearly parallel inside a given domain. Thus, these atomic steps 3 have nearly the same orientation. In general, the orientation of atomic steps 3 inside a given domain does not depend on the orientation in the adjacent domains. However, in the case of domains corresponding to annealing twins, the orientation of atomic steps 3 mirrors that of its neighboring twin. In other words, the orientation of atomic steps 3 is preferably mirror-inverted with respect to its neighboring twin. Furthermore, the orientation of atomic steps 3 changes abruptly at the twin boundary. Again, this internal topography of the domains of the polycrystalline metal substrate is stamped or embossed on the single-layer graphene grown on the polycrystalline metal substrate. The resulting graphene topography is illustrated in the images C and D of Fig. 1. The present application refers to this second aspect.

Accordingly, image C of Fig. 1 illustrates the stamp or embossment left by the atomic steps 3 inside a domain of the polycrystalline metal substrate on the single-layer graphene grown on top of the polycrystalline metal substrate. As a result, nanoripples 4 are formed. The nanoripples 4 are predominantly one-dimensional structures, a kind of lengthy corrugations. The nanoripples 4 have a length preferably of about 2 µm to 1000 µm. Adjacent nanoripples are essentially parallel. Furthermore, the nanoripples 4 are quasi-periodically spaced. The distance between adjacent nanoripples 4 is preferably between 250 nm and 500 nm. In this example, there are fluctuations in the periodicity of the distance between adjacent nanoripples 4. These fluctuations are preferably below 10 %.

Image D of Fig. 1 shows a magnified view of the profile of a nanoripple 4 from image C. Accordingly, the illustrated nanoripple 4 has a height in the range of 0,8 nm to 4,2 nm and a width in the range of 95 nm to 120 nm.

The electrical properties such as the charge mobility of graphene, in particular of CVD single-layer graphene, depend on the surface density of the nanoripples 4. More specifically, it has been found that the presence of nanoripples 4 sets an upper limit to charge mobility on graphene. Since the surface density of the nanoripples 4 along a given direction depends on the orientation of the nanoripples 4 with respect to this direction, the knowledge of the distribution and orientation of the nanoripples 4 is crucial for practical applications of graphene for electronics. Therefore, it is of great interest to determine the orientation of the nanoripples 4.

Apart from graphene, it has been found that also other two-dimensional materials produced by the CVD process using a polycrystalline metal or a single crystal of a metal as a substrate such as hexagonal boron nitride (h-BN) exhibit also the formation of nanoripples 4.

According to the present application, the distribution and orientation of the nanoripples 4 is determined by the simple and broadly available method of polarized optical microscopy using a polarization microscope, i. e. an optical microscope additionally having two polarizing filters, analyzer (A) and polarizer (P), with their optical axes aligned orthogonally to each other, and optionally a rotatable specimen stage.

A complete monolayer of graphene or hexagonal boron nitride (h-BN) with 100% coverage is invisible to common or polarized optical microscopy. Thus, these methods are unsuitable for investigating the topography of pristine samples of CVD graphene or hexagonal boron nitride (h-BN). It has been found that the deposition of a solid film of an electrically conductive imaging material onto two-dimensional materials such as CVD graphene or hexagonal boron nitride (h-BN) enables the use of polarized optical microscopy for determining the distribution and orientation of the nanoripples 4. The imaging material is preferably deposited shaped as nanometer-size elements. The orientation of the nanometer-size elements is dictated by the orientation of the periodically spaced nanoripples 4 of the two-dimensional material. Such nanometer-size elements are preferably electrically conductive nanowires, nanotubes, nanofibers or chains of nanoparticles. The imaging material is preferably an electrically conductive polymer, in particular (SN)ₓ, preferably shaped as chains of nanoparticles and/or nanofibers. (SN)ₓ stands for polymeric sulfur nitride and is also known as polythiazyl in older literature. In the case of nanowires and/or nanotubes they are preferably formed from metals, in particular silver nanowires, tellurium nanowires and/or tellurium nanotubes.

In the present examples, the imaging material is deposited onto the surface of the two-dimensional material such as graphene or hexagonal boron nitride (h-BN) by means of thermal vaporization. In the case of providing (SN)ₓ as imaging material, the thermal vaporization is preferably performed at a pressure in the range of 5*10⁻⁴ to 0,25 mbar. Furthermore, the thermal vaporization is preferably performed by heating the (SN)ₓ to a temperature in the range of 155 to 175°C, such as to about 170°C. In the present example, between three and four layers of (SN)ₓ with a total average thickness of 89,4 nm and a mass of 20,6 µg per cm² have been deposited onto the surface of the two-dimensional material for providing the film of the imaging material.

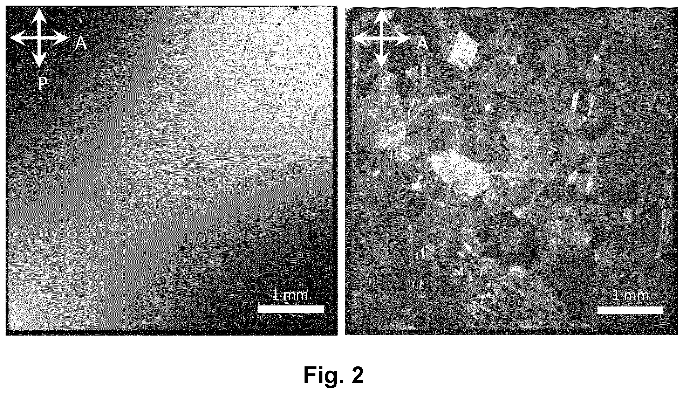

Fig. 2 shows a comparison of polarized optical microscopy images of a first sample of CVD single-layer graphene on a 5 mm x 5 mm SiO₂/Si substrate before and after the deposition of (SN)ₓ. The polarized optical microscopy has been performed in reflection with a magnification of 1,25x. The substrate size is 5 mm x 5 mm. In the pristine single-layer graphene (left image), there is no contrast at all. No domains can be visualized, only major defects such as wrinkles and holes in the graphene single layer. After the deposition of (SN)ₓ, the individual domains stamped onto the single-layer graphene, randomly distributed across the entire graphene single layer, become clearly visible (right image).

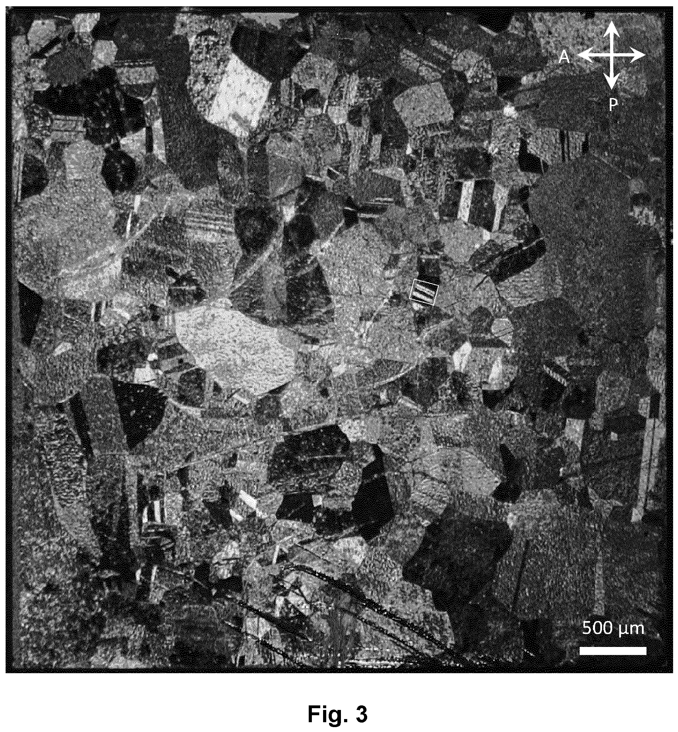

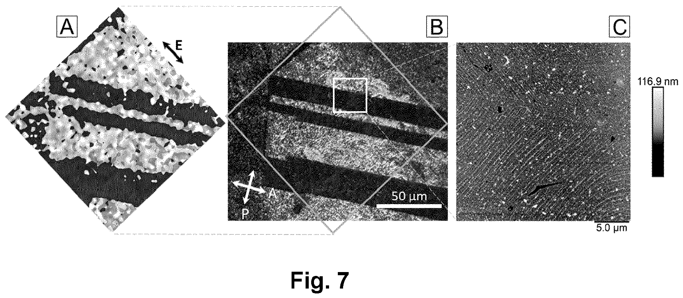

Fig. 3 shows an enlarged view of the right image, i. e. of the polarized optical microscopy image of the first sample of CVD single-layer graphene on the SiO₂/Si substrate after the deposition of (SN)ₓ. The domains observed in this first sample have an essentially polygonal form and have lateral dimensions of about 20 µm to 1000 µm. The color and/or the brightness of the individual domains depend on the respective orientation of the nanoripples 4. The small box in the center part of this image encloses multiple narrow parallel twins down to 5 µm width and will be addressed when discussing Fig. 7.

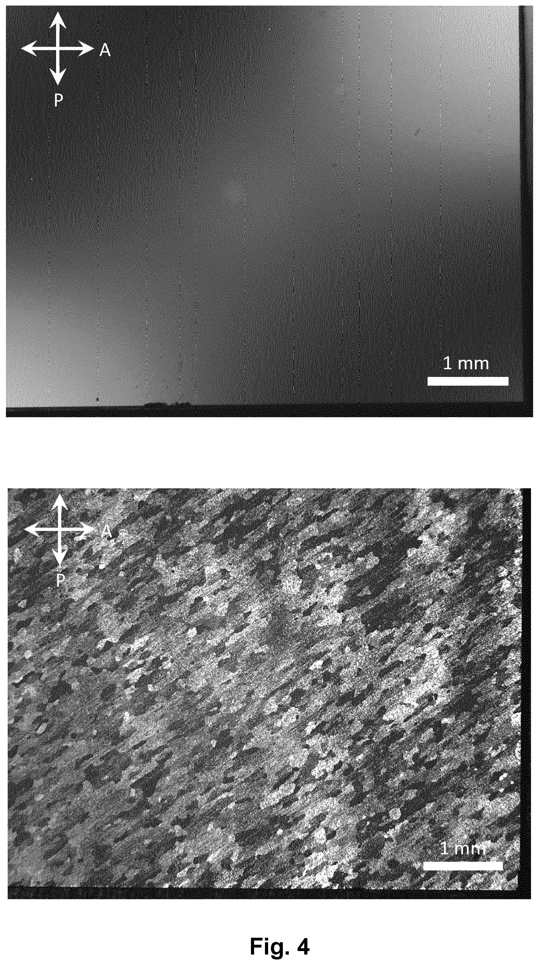

Fig. 4 shows a comparison of polarized optical microscopy images of a second sample of CVD single-layer graphene on a 1 cm x 1 cm SiO₂/Si substrate before and after the deposition of (SN)ₓ. Again, polarized optical microscopy has been performed in reflection with a magnification of 1,25x. In the pristine single-layer graphene (upper image), no domains can be visualized and major defects are not present. After the deposition of (SN)ₓ, individual domains become visible (lower image). Similar to the first sample, the domains are distributed across the entire graphene single layer. However, their distribution is not random, the domains appear elongated along a preferred direction. These domains are smaller and more uniform in size than the domains observed in the first sample of CVD single-layer graphene. These differences arise directly from the differing domain distribution of the polycrystalline metal substrates used for growing the first and the second sample of CVD single-layer graphene. These strikingly different domain distributions are faithfully stamped onto the respective single-layer graphene of the first and the second sample.

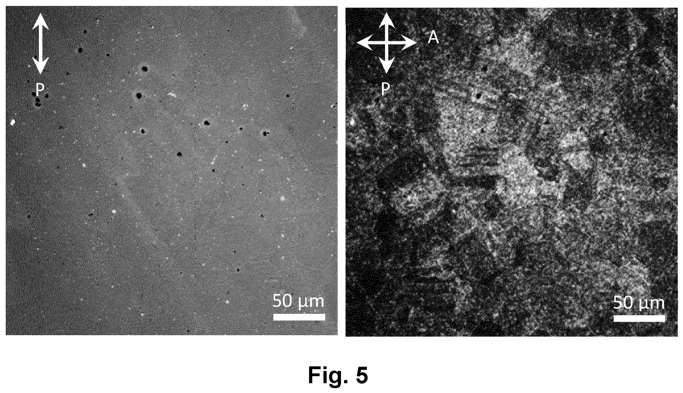

Fig. 5 shows polarized optical microscopy images of a third sample of CVD single-layer hexagonal boron nitride (h-BN) on a SiO₂/Si substrate after the deposition of (SN)ₓ. The polarized optical microscopy has been performed in reflection with a magnification of 20x. The respective images are taken with and without crossed analyzer (A). For taking the left image, the analyzer (A) was removed. For this sample, no domains can be visualized, only major defects such as holes in the hexagonal boron nitride (h-BN) single layer. Thus, for this sample, the absolute orientation of the nanoripples 4 would have to be determined by combining the polarized optical microscopy images with complementary microscopy methods such as atomic force microscopy (AFM). In the right image, the analyzer (A) is in a crossed position with respect to the polarizer (P). Individual domains stamped onto the single-layer hexagonal boron nitride (h-BN) are clearly visible. Again, the color and/or the brightness of the individual domains depend on the respective orientation of the nanoripples 4.

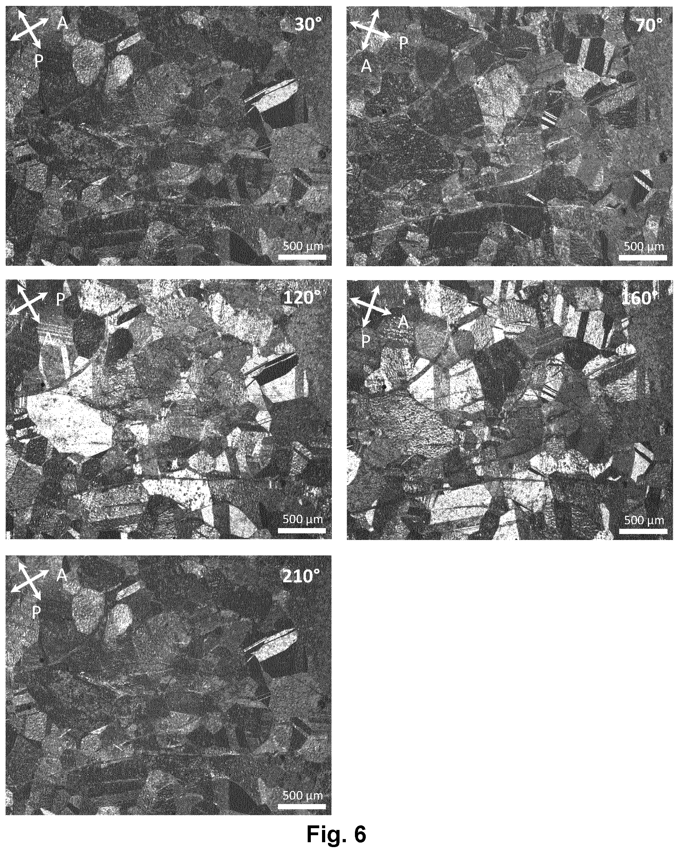

Fig. 6 shows a sequence of polarized optical microscopy images of the first sample of CVD single-layer graphene on SiO₂/Si substrate. The polarized optical microscopy has been performed in reflection with a magnification of 2,5x. The respective images have been taken at different acquisition angles. By imaging the sample at different acquisition angles, the orientation of the periodically spaced nanoripples is determined. More specifically, for realizing different acquisition angles, the sample has been rotated in the XY plane, i. e. in the horizontal plane. A first image has been taken at an acquisition angle of 30° (upper left image). After rotating to an acquisition angle of 70°, a second image has been taken (upper right image). After rotating to an acquisition angle of 120°, a third image has been taken (center left image). Again, after rotating to an acquisition angle of 160°, a fourth image has been taken (center right image). Finally, after rotating to an acquisition angle of 210°, a fifth image has been taken (lower left image). In the respective images, the same domains are observed at different acquisition angles. However, according to the acquisition angle, the color and/or the brightness of the individual domains changes depending on the respective orientation of the nanoripples 4. Depending on the succession of the color and/or the brightness of the individual domains 1, the relative orientation of the individual domains is evaluated. Domains which show the same succession have the same orientation of the nanoripples 4. Furthermore, observing a domain that shows a succession which is shifted by an angle of e. g. 40° with respect to another domain 1, the orientation of the nanoripples 4 between these two domains differs also by this angle, e. g. 40°. Thus, by imaging the samples at different acquisition angles, the relative angles of orientation of the nanoripples 4 in the respective domains are determined. In knowledge of any absolute orientation of the nanoripples 4 inside one domain, the absolute orientations of the nanoripples 4 in all other domains are determined.

The absolute orientation of the nanoripples 4 in a specific domain can be determined by complementary microscopy methods. Alternatively, it can also be determined by polarized optical microscopy, provided that the images exhibit enough contrast between the different domains with the analyzer (A) removed from the optical path.

Fig. 7 shows images of the layered composite of (SN)ₓ on the first sample of CVD single-layer graphene on SiO₂/Si substrate by complementary microscopy methods.

Image B of Fig. 7 presents an overview of the investigated area corresponding to the area highlighted by a small box in the center part of Fig. 3. For the image in Fig. 7, polarized optical microscopy has been performed in reflection with a magnification of 50x. The images A and C are also generated from this same area, the image A by Raman microscopy and the image C by atomic force microscopy (AFM).

Image A of Fig. 7 shows a Raman microscopy map. The mapping size is 122,5 µm x 122,5 µm. The investigated area is enclosed by the tilted frame shown in image B. The arrow shows the orientation of the electric field vector E of the linear polarized laser light used for excitation. The wavelength of the linear polarized laser light used for excitation (λ_{exc}.) is 633 nm. The intensity of the Raman signal coming from (SN)ₓ shaped as chains of nanoparticles and/or nanofibers depends on their orientation relative to the orientation of the electric field vector E. The orientation of the (SN)ₓ chains of nanoparticles and/or nanofibers follows, in turn, the orientation of the nanoripples 4 of graphene. Therefore, the intensity of the Raman signal depends directly on the orientation of the nanoripples 4 inside a given domain. Domains where the nanoripples 4 are oriented parallel to the electric field vector E exhibit maximal intensity and are displayed with a higher brightness. Conversely, domains where the nanoripples 4 are oriented perpendicular to the electric field vector E exhibit minimal intensity and are displayed darker. Thus, by acquiring Raman maps of the samples at different acquisition angles, either by rotating the sample or by rotating the electric field vector E of the laser source, the absolute orientation of the nanoripples 4 inside the respective domains can be determined. Accordingly, the nanoripples 4 inside the brighter domains shown in image B are oriented parallel to the direction of the electric field vector E, while the nanoripples 4 inside the darker domains are oriented normal to the electric field vector E.

Image C of Fig. 7 is an atomic force microscopy (AFM) image of the inset shown in image B. The scanned area is 25,6 µm x 25,6 µm. The height information is shown. The elevated parts of the topography are displayed with a higher brightness. From image C, the absolute orientation, the distance between adjacent nanoripples 4 and its periodicity is determined. Accordingly, in the upper third of image C, a twin boundary running slightly tilted from left to right separates two twin domains. The nanoripples 4 inside the upper domain are oriented at an angle of 38°, measured clockwise from the twin boundary, while the nanoripples 4 inside the lower domain are oriented at an angle of 61°, measured counterclockwise from the twin boundary. Besides, by analyzing the atomic force microscopy (AFM) image, it is possible to determine the distance between adjacent nanoripples 4 and its periodicity. In image C, the surface density of the nanoripples 4 inside the upper domain, measured normal to their preferred orientation direction, is considerably higher than the surface density of the nanoripples 4 inside the lower domain. Accordingly, the period between nanoripples 4 for the upper domain fluctuates between 210 nm and 330 nm, while for the lower domain fluctuates between 460 nm and 770 nm.

### Reference signs

- 1a: grains of the polycrystalline metal substrate
- 1b: twins
- 2: graphene crystal or grain
- 3: atomic step
- 4: nanoripple

- A: analyzer
- P: polarizer
- E: electric field vector

## Claims

1. A method of visualizing a distribution and an intrinsic orientation of periodically spaced one-dimensional structures by optical microscopy,
wherein the periodically spaced one-dimensional structures are distributed inside a single domain or inside multiple domains on a two-dimensional material,
wherein, inside each domain, the periodically spaced one-dimensional structures run essentially in parallel, wherein the distance between adjacent periodically spaced one-dimensional structures is in the range of 50 nm - 1000 nm, preferably in the range of 100 nm - 800 nm, more preferably in the range of 200 nm - 600 nm, most preferably in the range of 250 nm - 500 nm, wherein the method comprises the following steps:
a) depositing an electrically conductive solid film of an imaging material onto the surface of the two-dimensional material to obtain a layered composite,
b) providing a polarization microscope,
c) imaging the layered composite obtained in step a) at different acquisition angles by polarized optical microscopy using the polarization microscope and analyzing the images to determine the distribution and the orientation of the periodically spaced one-dimensional structures inside the respective domains.

2. The method according to claim 1, wherein the two-dimensional material is produced by chemical vapor deposition, atomic layer deposition, physical vapor deposition, sputtering, evaporation and/or epitaxy.

3. The method according to claim 1 or 2, wherein the two-dimensional material is produced on a metallic substrate, wherein the metallic substrate is preferably polycrystalline or a single crystal.

4. The method according to any one of the preceding claims, wherein the two-dimensional material is graphene, preferably a single layer of graphene, or hexagonal boron nitride, preferably a single layer of hexagonal boron nitride.

5. The method according to any one of the preceding claims, wherein the periodically spaced one-dimensional structures form lengthy essentially parallel corrugations having a height in the range of 0,5 nm to 10 nm, preferably a height in the range of 0,6 nm to 6 nm, more preferably a height in the range of 0,8 nm to 4,2 nm, most preferably a height of about 2,5 nm.

6. The method according to any one of the preceding claims, wherein the imaging material is electrically conductive and is preferably deposited shaped as nanometer-size elements, wherein the orientation of the nanometer-size elements is preferably dictated by the orientation of the periodically spaced one-dimensional structures of the two-dimensional material,
wherein the nanometer-size elements are preferably electrically conductive nanowires, nanotubes, nanofibers and/or chains of nanoparticles,
wherein the nanometer-size elements preferably have diameters and/or widths in the range of 20 nm to 200 nm, most preferably in the range of 40 nm to 180 nm and most preferably in the range of 55 nm to 160 nm and/or lengths in the range of 100 nm to 100 µm, preferably in the range of 500 nm to 40 µm, and most preferably in the range of 1 µm to 20 µm.

7. The method according to any one of the preceding claims, wherein the imaging material is an electrically conductive polymer, in particular (SN)ₓ, or wherein the imaging material is a metal shaped as nanowires and/or nanotubes, in particular silver nanowires, tellurium nanowires and/or tellurium nanotubes.

8. The method according to any one of the preceding claims, wherein the imaging material is deposited onto the surface of the two-dimensional material in step a) by means of thermal vaporization,
wherein the thermal vaporization is preferably performed at 10⁻⁸ to 20 mbar, more preferably 10⁻⁶ to 0,5 mbar, most preferably 10⁻⁴ to 10⁻¹ mbar,
wherein the precursor of the imaging material is preferably kept at a temperature above its transition temperature at the prevailing pressure, while the two-dimensional material is kept at a temperature below the transition temperature of the imaging material.

9. The method according to any one of the preceding claims, wherein the quantity of the imaging material deposited in step a) is large enough to evenly cover the entire surface of the two-dimensional material or of a selected area of the two-dimensional material with imaging material.

10. The method according to any one of the preceding claims, wherein, in step a), between 1 and 20 layers of the imaging material, preferably between 2 and 10 layers of the imaging material and most preferably between 3 and 4 layers of the imaging material are deposited onto the surface of the two-dimensional material.

11. The method according to any one of the preceding claims, wherein the following step is performed before or after performing step c):
d) imaging the layered composite obtained in step a) by complementary microscopy methods, preferably by Raman microscopy or/and by atomic force microscopy (AFM).

12. The method according to any one of the preceding claims, wherein the film of imaging material deposited in step a) is removable from the two-dimensional material.

13. The method according to any one of the preceding claims, wherein the following step is performed after performing the step c) and/or after step d): e) removing the film of imaging material deposited in step a).

14. Use of (SN)ₓ deposited on a two-dimensional material, preferably on graphene or on hexagonal boron nitride, in polarized optical microscopy, preferably in a method according to any one of the preceding claims.

15. A method of production of a two-dimensional material, preferably of graphene or hexagonal boron nitride, comprising the method of visualization according to any one of the claims 1 to 13 for controlling the quality of the two-dimensional material, in particular graphene or hexagonal boron nitride.
